# EUROPEAN PATENT APPLICATION

(11) **EP 1 909 309 A1**
(43) Date of publication of application: **09.04.2008**
(21) Application number: 05762078.3
(22) Date of filing: 22.07.2005
(51) Int. Cl.: H01L 21/02, H01L 27/12

(54) **METHOD FOR MANUFACTURING SIMOX WAFER AND SIMOX WAFER MANUFACTURED BY SUCH METHOD**

(71) Applicant: SUMCO Corporation, Tokyo 105-8634 (JP)
(72) Inventor: TAKAHASHI, Isao SUMCO CORPORATION, Tokyo105-8634 (JP); NAKAI, Tetsuya SUMCO CORPORATION, Tokyo105-8634 (JP)
(74) Representative: Albrecht, Thomas
(86) International application number: PCT/JP2005/013498
(87) International publication number: WO 2007/010619

(57) **Abstract**

This method for manufacturing a SIMOX wafer, includes: implanting oxygen ions in a silicon wafer; cleaning said silicon wafer into which said oxygen ions are implanted; and forming a buried oxide film within an interior of said silicon wafer by subjecting said cleaned silicon wafer to a heat treatment, wherein said method further includes immersing said silicon wafer in an aqueous solution of hydrofluoric acid and etching a SiO₂ film formed on a surface of said silicon wafer, which is conducted after said implanting of oxygen ions in said silicon wafer, but prior to said cleaning of said silicon wafer, and an etching rate for said SiO₂ film by said aqueous solution of hydrofluoric acid during said etching treatment is within a range from 150 to 3,000 (Å/minute).

## Description

### TECHNICAL FIELD

The present invention relates to a method for manufacturing a SIMOX (Separation by Implanted Oxygen) wafer that includes implanting oxygen ions into the interior of a silicon wafer, subsequently conducting a heat treatment to form a buried oxide film in a region at a predetermined depth from the wafer surface, and then forming a SOI (Silicon on Insulator) layer in the surface of the wafer.

### BACKGROUND ART

In conventional SIMOX wafer manufacturing processes, it is known that particles that adhere to the wafer during the oxygen ion implantation act as nuclei for the formation of defects during the subsequent annealing treatment, and these particles must therefore be removed prior to the annealing treatment. Examples of the methods used for removing these particles generally include cleaning methods that use a mixed solution of ammonia water, hydrogen peroxide and pure water (hereafter referred to as an SC-1 cleaning solution), cleaning methods that use a mixed solution of sulfuric acid, hydrogen peroxide and pure water, cleaning methods that use an aqueous solution containing ozone water and a concentration of 0.2 to 2% by weight of hydrofluoric acid, and cleaning methods that employ a combination of the above cleaning methods. However, even when a wafer is cleaned using the above cleaning methods, the maximum particle removal ratio at the wafer surface is approximately 80%, meaning the wafer proceeds to the annealing step with residual particles on the wafer surface, and it has been assumed that there is therefore a limit to the reduction that can be achieved in the level of wafer defects. The particle removal ratio can be determined by measuring the numbers of particles with particle sizes of 0.20 µm or greater, before and then after cleaning, using a SurfScan 6420 (a surface detection apparatus, manufactured by KLA-Tencor Corporation, U.S.A.).

On the other hand, a method for manufacturing a semiconductor has been disclosed in which cleaning is conducted during the step of implanting oxygen ions in the silicon wafer, wherein the cleaning involves jet cleaning using a stream of ultrasound-energized water, cleaning using an SC-1 cleaning solution, or cleaning using a mixed solution of hydrochloric acid, hydrogen peroxide and pure water (for example, see Patent Document 1). This method for manufacturing a semiconductor includes steps for forming a surface oxide film in the silicon wafer prior to the oxygen ion implantation, and then removing the surface oxide film partway through the oxygen ion implantation process using a dilute aqueous solution of hydrofluoric acid.

In this type of method for manufacturing a semiconductor, by cleaning the wafer and conducting particle removal partway through the oxygen ion implantation process, the surface area of the wafer blocked by particles can be reduced during the following oxygen ion implantation. Therefore, current path defects within the buried oxide film can be reduced. Furthermore, because oxygen ion implantation into the wafer is conducted with a surface oxide film already formed in the wafer, and this surface oxide film is then removed using a dilute aqueous solution of hydrofluoric acid partway through the step of implanting oxygen ions into the wafer, particles adhered to the surface of the surface oxide film are removed at the same time as the surface oxide film. Therefore, the quantity of particles on the wafer surface is able to be effectively reduced.

However, in the conventional method for manufacturing a semiconductor disclosed in the Patent Document 1, the concentration of the aqueous solution of hydrofluoric acid is low, and the etching rate for the surface oxide film is low. As a result, although the surface oxide film is able to be removed, complete removal of particles that have bonded strongly via silicon and oxygen chemical bonds during the oxygen ion implantation process is difficult. Therefore, even with this method, the maximum removal ratio is only approximately 80%. If a SIMOX wafer is manufactured in this state, then deep defects that penetrate through the SOI layer and have an adverse effect on the electrical properties of the wafer (defects that are observed after immersion of the wafer for 30 minutes at a temperature of 23°C in an aqueous solution of hydrofluoric acid with a concentration of 50% by weight) still exist in considerably large quantities.

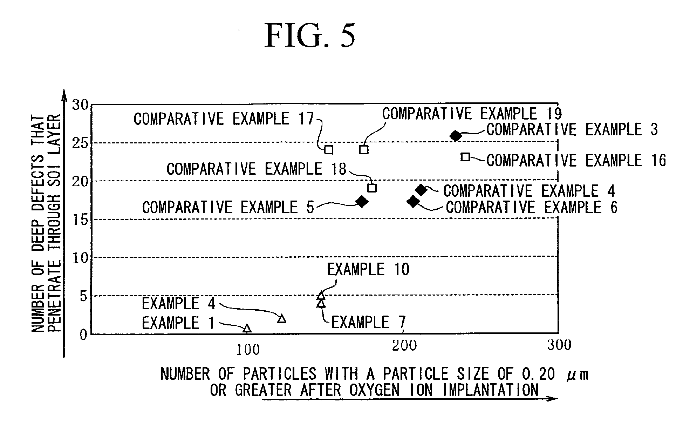

Patent Document 1: Japanese Unexamined Patent Application, First Publication No. Hei 08-78647(claims 1 to 5, paragraph (0019), paragraph (0024), and FIG. 5)

### DISCLOSURE OF INVENTION

### PROBLEMS TO BE SOLVED BY THE INVENTION

An object of the present invention is to provide a method for manufacturing a SIMOX wafer that enables the efficient removal of particles that have adhered to the wafer during oxygen ion implantation and enables a reduction in the quantity of deep defects that penetrate through the SOI layer within the SIMOX structure, and to also provide a SIMOX wafer manufactured by such a method.

### MEANS FOR SOLVING THE PROBLEMS

One aspect of the method for manufacturing a SIMOX wafer according to the present invention provides an improvement on a method for manufacturing a SIMOX wafer that includes implanting oxygen ions in a silicon wafer, cleaning the silicon wafer into which the oxygen ions have been implanted, and forming a buried oxide film within the interior of the silicon wafer by subjecting the cleaned silicon wafer to a heat treatment.

The special feature of this improved method involves the inclusion of immersing the silicon wafer in an aqueous solution of hydrofluoric acid and etching the SiO₂ film formed in the surface of the silicon wafer, which is conducted after the implanting of oxygen ions in the silicon wafer but prior to the cleaning of the silicon wafer, and the etching rate for the SiO₂ film by the aqueous solution of hydrofluoric acid during this etching treatment is within a range from 150 to 3,000 Å/minute.

According to this aspect of the method for manufacturing a SIMOX wafer according to the present invention, because the silicon wafer is immersed within an aqueous solution of hydrofluoric acid by which the etching rate for the SiO₂ film in the wafer surface is within a range from 150 to 3,000 Å/minute, the surface of the silicon wafer can be etched at a rapid rate. Because the etching rate for silicon dioxide is high during this etching step, strong particle bonds containing large quantities of silicon and oxygen bonds are also broken. As a result, particles can be almost completely removed from the surface of the silicon wafer.

In the one aspect of the method for manufacturing a SIMOX wafer according to the present invention, the oxygen ion implantation into the silicon wafer may be conducted over a plurality of steps, and the silicon wafer may be immersed in the aqueous solution of hydrofluoric acid either immediately after any one of the oxygen ion implantation steps, or immediately after each of two or more of the implantation steps.

In such cases, if the wafer surface treatment is conducted by immersion of the wafer in the aqueous solution of hydrofluoric acid immediately after one of the plurality of oxygen ion implantation steps, for example, immediately after the first oxygen ion implantation step, the quantity of residual particles on the wafer surface is reduced prior to the next oxygen ion implantation step. As a result, since the oxygen ion implantation blocking effect caused by the particles is reduced, the quantity of deep defects that penetrate through the SOI layer (defects that are observed after immersion of the wafer for 30 minutes at a temperature of 23°C in an aqueous solution of hydrofluoric acid with a concentration of 50% by weight) within the wafer that has undergone the SIMOX heat treatment step can be reduced.

Furthermore, in the one aspect of the method for manufacturing a SIMOX wafer according to the present invention, the temperature of the aqueous solution of hydrofluoric acid may exceed the freezing point of this aqueous solution of hydrofluoric acid 12 and be not greater than 40°C, and the immersion time for the silicon wafer within the aqueous solution of hydrofluoric acid may be within a range from 10 to 600 seconds.

Moreover, in the one aspect of the method for manufacturing a SIMOX wafer according to the present invention, if the etching rate for the SiO₂ film by the aqueous solution of hydrofluoric acid 12 is termed R (Å/minute), and the immersion time of the silicon wafer 11 within the aqueous solution of hydrofluoric acid 12 is termed H (seconds), then the immersion time may be set so that H ≥ (1500/R) (seconds).

In the one aspect of the method for manufacturing a SIMOX wafer according to the present invention, a surfactant may be added to the aqueous solution of hydrofluoric acid.

In such a case, when the silicon wafer is lifted out of the aqueous solution of hydrofluoric acid containing the added surfactant, the surfactant acts as a protective film on the wafer surface. Therefore, re-attachment of particles to the wafer surface can be prevented. Furthermore, if the wafer is then rinsed in pure water, the surfactant promotes favorable water removal.

One aspect of a SIMOX wafer according to the present invention is a wafer that is manufactured using the method for manufacturing a SIMOX wafer of the present invention, and has a quantity of deep defects that penetrate through the SOI layer (defects that are observed after immersion of the wafer for 30 minutes at a temperature of 23°C in an aqueous solution of hydrofluoric acid with a concentration of 50% by weight) of not more than 0.05 defects/cm².

In this aspect of the SIMOX wafer of the present invention, by manufacturing the wafer using the method for manufacturing a SIMOX wafer according to the present invention, the quantity of residual particles on the wafer surface can be reduced prior to the oxygen ion implantation. As a result, since the oxygen ion implantation blocking effect caused by the particles is reduced, the quantity of deep defects that penetrate through the SOI layer (defects that are observed after immersion of the wafer for 30 minutes at a temperature of 23°C in an aqueous solution of hydrofluoric acid with a concentration of 50% by weight) can be reduced dramatically.

### EFFECTS OF THE INVENTION

According to the present invention, a step of immersing the silicon wafer in an aqueous solution of hydrofluoric acid and etching the SiO₂ film formed in the surface of the silicon wafer is conducted after the implanting of oxygen ions in the silicon wafer but prior to the cleaning of the silicon wafer, and the etching rate for the SiO₂ film by the aqueous solution of hydrofluoric acid during this etching treatment is within a range from 150 to 3,000 Å/minute, and as a result, the surface of the silicon wafer is etched at a rapid rate. Because the etching rate for silicon dioxide is high during this etching treatment, strong particle bonds containing large quantities of silicon and oxygen bonds are also broken. As a result, particles can be almost completely removed from the surface of the silicon wafer.

If the oxygen ion implantation into the silicon wafer is conducted over a plurality of steps, and the silicon wafer is immersed in the aqueous solution of hydrofluoric acid either immediately after any one of the oxygen ion implantation steps, or immediately after each of two or more of the implantation steps, the quantity of residual particles on the wafer surface can be reduced prior to the next oxygen ion implantation step. As a result, the oxygen ion implantation blocking effect caused by the particles is reduced. Consequently, the quantity of deep defects that penetrate through the SOI layer (defects that are observed after immersion of the wafer for 30 minutes at a temperature of 23°C in an aqueous solution of hydrofluoric acid with a concentration of 50% by weight) within the wafer that has undergone the SIMOX heat treatment step can be reduced.

Furthermore, if a surfactant is added to the aqueous solution of hydrofluoric acid, then when the silicon wafer is lifted out of the aqueous solution of hydrofluoric acid containing the added surfactant, the surfactant acts as a protective film on the wafer surface. As a result, re-attachment of particles to the wafer surface can be prevented, and if the wafer is then rinsed in pure water, the surfactant promotes favorable water removal.

Moreover, in a SIMOX wafer manufactured using the above method, the quantity of deep defects that penetrate through the SOI layer (defects that are observed following immersion of the wafer for 30 minutes at a temperature of 23°C in an aqueous solution of hydrofluoric acid with a concentration of 50% by weight) can be reduced dramatically to not more than 0.05 defects/cm².

### BRIEF DESCRIPTION OF THE DRAWINGS

FIG. 1 is a diagram of an embodiment according to the present invention, showing an etching treatment step using an aqueous solution of hydrofluoric acid with an etching rate of 150 to 3,000 Å/minute, and a rinsing step using pure water.
FIG. 2 is a block diagram that includes a step of implanting oxygen ions into a silicon wafer and a cleaning step according to an embodiment of the present invention.
FIG. 3A is a chart showing the particle removal ratios for Examples 1 to 12.
FIG. 3B is a chart showing the particle removal ratios for Comparative Examples 1 to 13.
FIG. 3C is a chart showing the particle removal ratios for Comparative Examples 14 to 26.
FIG. 4A is a chart showing the particle removal ratios for Comparative Examples 27 to 39.
FIG. 4B is a chart showing the particle removal ratios for Comparative Examples 40 to 52.
FIG. 5 is a chart showing the numbers of deep defects that penetrate through the SOI layer (defects that are observed after immersion of the wafer for 30 minutes at a temperature of 23°C in an aqueous solution of hydrofluoric acid with a concentration of 50% by weight) for the Examples and Comparative Examples.

### DESCRIPTION OF REFERENCE SYMBOLS

- 11: Silicon wafer
- 12: Aqueous solution of hydrofluoric acid

### BEST MODE FOR CARRYING OUT THE INVENTION

As follows is a description of preferred embodiments for implementing the present invention, based on the drawings.

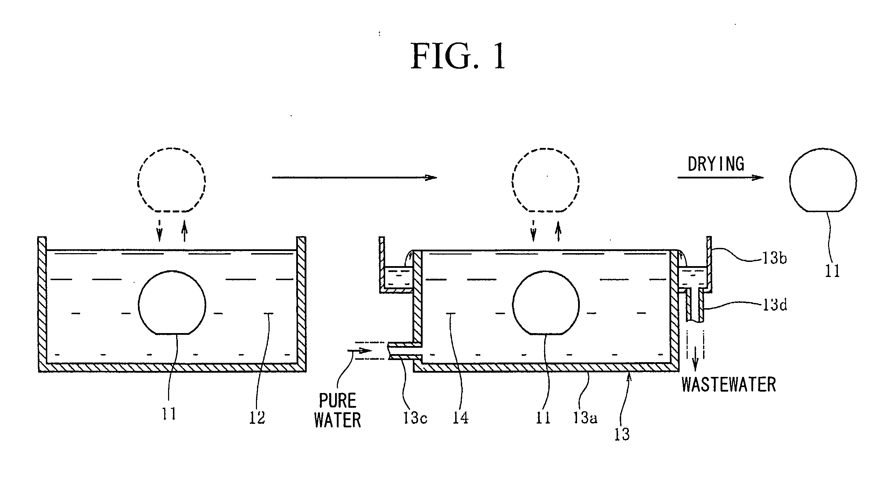

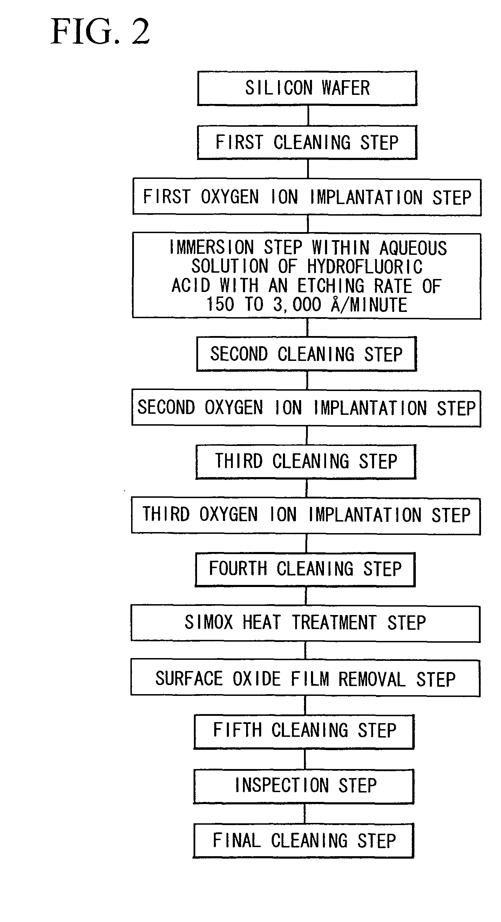

As shown in FIG. 1 and FIG. 2, the method for manufacturing a SIMOX wafer includes: implanting oxygen ions in a silicon wafer 11; cleaning the wafer 11 into which the oxygen ions have been implanted; and forming a buried oxide film within the interior of the wafer 11 by subjecting the cleaned wafer 11 to a heat treatment.

In this embodiment, the oxygen ion implantation is divided into three stages.

Furthermore, examples of the method used for cleaning the wafer 11 include cleaning methods that use an SC-1 cleaning solution, cleaning methods that use a mixed solution of sulfuric acid, hydrogen peroxide and pure water, cleaning methods that use a mixed solution of hydrochloric acid, hydrogen peroxide and pure water, cleaning methods that use an aqueous solution containing ozone water and a concentration of 0.2 to 2% by weight of hydrofluoric acid, cleaning methods that employ a combination of the above cleaning methods, and cleaning methods that employ a combination of the above cleaning methods and megasonic cleaning. Here, the term "megasonic cleaning" describes cleaning in which hypersonic waves of 0.8 to 10 MHz are irradiated onto the object undergoing cleaning within a liquid.

A silicon ingot that has been pulled up using the Czochralski method is sliced, the resulting surfaces are polished, and then each wafer is cleaned in a first cleaning step (FIG. 2). The cleaned wafer 11 is then subjected to a first implantation of oxygen ions (the first oxygen ion implantation step). This oxygen ion implantation is conducted at an oxygen ion dose within a range from 5 × 10¹⁶ to 2 × 10¹⁷ atoms/cm² while the wafer 11 is heated at a temperature within a range from 300 to 500°C.

Subsequently, prior to cleaning of the wafer 11, the wafer 11 is immersed in an aqueous solution of hydrofluoric acid 12, and a SiO₂ film formed in the surface of the wafer 11 is subjected to an etching treatment (FIG. 1 and FIG. 2).

The etching rate for the SiO₂ film by the aqueous solution of hydrofluoric acid 12 during this etching treatment is within a range from 150 to 3,000 Å/minute, preferably from 500 to 1,000 Å/minute, and is more preferably from 500 to 600 Å/minute. The concentration of the aqueous solution of hydrofluoric acid required to achieve an etching rate within a range from 150 to 3,000 Å/minute is from 2.5 to 50% by weight at 23°C, the concentration of the aqueous solution of hydrofluoric acid required to achieve an etching rate within a range from 500 to 1,000 Å/minute is from 10 to 20% by weight at 23°C, and the concentration of the aqueous solution of hydrofluoric acid required to achieve an etching rate within a range from 500 to 600 Å/minute is from 10 to 12% by weight at 23°C.

Because the above etching treatment etches the surface of the wafer 11 at a rapid rate, strong particle bonds that contain large quantities of silicon and oxygen bonds are broken and removed at the same time as the natural oxide film in the surface of the wafer 11, meaning that in other words, the chemical bonds to those particles that bonded strongly to the wafer surface via silicon and oxygen during the oxygen ion implantation are also broken.

Specifically, in the case of chemical bonding between oxygen and a particle, it is thought that not only a single bond, but rather a plurality of bonds, exist to each particle. In order to break these bonds, either HF or HF₂⁻ must encounter the Si-O bond, and the probability of this encounter is rate-controlling.

Breaking a plurality of bonds that exist with a physically restricted space tends to be problematic using an aqueous solution of hydrofluoric acid by which the etching rate is less than 150 Å/minute, because the HF or HF₂⁻ moieties tend to be consumed as a result of encountering a Si-O bond prior to reaching the innermost portions, meaning that the innermost portions of the restricted space remain out of reach.

However, if the aqueous solution of hydrofluoric acid exhibits an etching rate within a range from 150 to 3,000 Å/minute, it is believed that HF or HF₂⁻ moieties still remain when the innermost portions of the restricted space are reached, enabling all of the plurality of bonds that exist within the restricted space to be broken. As a result, particles can be almost completely removed from the surface of the wafer 11.

The reason for the use of a method in which the wafer is immersed in the aqueous solution of hydrofluoric acid rather than a method in which the aqueous solution of hydrofluoric acid is sprayed onto a rotating wafer surface is described below. In the method in which the aqueous solution of hydrofluoric acid is sprayed onto the rotating wafer surface, the wafer surface becomes hydrophobic after dissolution of the natural oxide film in the wafer surface. Therefore, the aqueous solution of hydrofluoric acid becomes incapable of conforming to the wafer surface. As a result, the solution tends to roll across the surface as liquid droplets, and traces that are formed when these droplets dry and solidify remain on the wafer surface and are detected as particles, meaning that the wafer surface becomes covered with irregularities, and the quality of the wafer surface deteriorates unfavorably. Consequently, in the present embodiment, a method is employed in which the wafer is immersed in the aqueous solution of hydrofluoric acid.

Furthermore, if the wafer surface treatment involving immersion of the wafer in an aqueous solution of hydrofluoric acid by which the etching rate for the SiO₂ film is within a range from 150 to 3,000 Å/minute is substituted with a treatment that uses an SC-1 cleaning solution, the maximum etching rate for silicon and silicon dioxide (SiO₂) by the SC-1 cleaning solution is approximately 20 Å/minute. Even if the quantity of etching is increased by lengthening the treatment time, large quantities of non-removable fixed point particles remain, and these particles cause wafer defects.

Here, a "fixed point particle" refers to a particle that exists in the same position before and after the second cleaning step.

The temperature of the aqueous solution of hydrofluoric acid 12 exceeds the freezing point of the aqueous solution of hydrofluoric acid and is not greater than 40°C, and is preferably within a range from 20 to 25°C. The immersion time for the wafer 11 within the aqueous solution of hydrofluoric acid 12 is typically within a range from 10 to 600 seconds, and is preferably from 30 to 100 seconds.

If the etching rate for the SiO₂ film by the aqueous solution of hydrofluoric acid 12 is less than 150 Å/minute, the etching rate at the surface of the wafer 11 is slow, and strong particle bonds containing large quantities of silicon and oxygen bonds cannot be broken, meaning that in other words, the chemical bonds to those particles that bonded strongly to the wafer surface via silicon and oxygen during the oxygen ion implantation cannot be broken. Furthermore, if the etching rate exceeds 3,000 Å/minute, the surface roughness of the wafer 11 tends to deteriorate. Accordingly, the etching rate for the SiO₂ film by the aqueous solution of hydrofluoric acid 12 is set within a range from 150 to 3,000 Å/minute.

Furthermore, if the temperature of the aqueous solution of hydrofluoric acid 12 is equal to or less than the freezing point of the aqueous solution of hydrofluoric acid, the etching treatment cannot be conducted. If the temperature exceeds 40°C, a mist is generated from the aqueous solution of hydrofluoric acid that not only makes handling difficult, but also causes a deterioration in the surface roughness. Accordingly, the temperature of the aqueous solution of hydrofluoric acid 12 is set within a range that exceeds the freezing point of the aqueous solution of hydrofluoric acid and is not greater than 40°C.

Moreover, if the immersion time of the wafer 11 within the aqueous solution of hydrofluoric acid 12 is less than 10 seconds, the immersion time is too short, and strong particle bonds containing large quantities of silicon and oxygen bonds cannot be broken, meaning that in other words, the chemical bonds to those particles that bonded strongly to the wafer surface via silicon and oxygen during the oxygen ion implantation cannot be broken. If the immersion time exceeds 600 seconds, the surface roughness deteriorates. Accordingly, the immersion time of the wafer 11 within the aqueous solution of hydrofluoric acid 12 is set within a range from 10 to 600 seconds.

Moreover, if the etching rate for the SiO₂ film formed in the surface of the wafer 11 by the aqueous solution of hydrofluoric acid 12 is termed R (Å/minute), and the immersion time of the wafer 11 within the aqueous solution of hydrofluoric acid 12 is termed H (seconds), the immersion time is preferably set so that H ≥ (1500/R) (seconds). This formula enables the ideal immersion time for the wafer 11 to be determined quickly based on the etching rate of the aqueous solution of hydrofluoric acid 12.

Furthermore, a surfactant is preferably also added to the aqueous solution of hydrofluoric acid 12. If a surfactant is added to the aqueous solution of hydrofluoric acid 12, the surfactant acts as a protective film on the surface of the wafer 11. Therefore, re-attachment of particles to the wafer surface can be prevented. Furthermore, if the wafer 11 is then rinsed in pure water, the surfactant promotes favorable water removal.

Suitable examples of the surfactant include ionic surfactants and nonionic surfactants. The quantity of the added surfactant is typically within a range from 0.1 to 10% by weight, and is preferably from 0.3 to 1% by weight.

If the quantity of the added surfactant is less than 0.1% by weight, the surfactant is unable to function as a protective film on the surface of the wafer 11, whereas if the quantity exceeds 10% by weight, salting out can occur, inhibiting the etching treatment. Accordingly, the quantity of the added surfactant is set within a range from 0.1 to 10% by weight.

Subsequently, the wafer 11 is immersed in a rinse tank 13 filled with pure water 14, and after the rinsing, the wafer 11 is lifted out and dried (FIG. 1). This rinse tank 13 includes a tank main body 13a that contains the pure water 14, and an overflow tank 13b which is provided around the outer periphery at the top edge of the tank main body 13a and collects the pure water 14 that overflows the tank main body 13a. Furthermore, a supply pipe 13c that supplies pure water 14 to the tank main body 13a is connected to the lower portion of the tank main body 13a, and a discharge pipe 13d that discharges the pure water 14 accumulated within the overflow tank 13b is connected to the bottom surface of the overflow tank 13b.

Subsequently, the wafer 11 is subjected to a second oxygen ion implantation step, a third cleaning step, a third oxygen ion implantation step and a fourth cleaning step, and then is subjected to a SIMOX heat treatment (FIG. 2).

The implantation of oxygen ions during the second oxygen ion implantation step is conducted at an oxygen ion dose within a range from 5 × 10¹⁶ to 2 × 10¹⁷ atoms/cm² while the wafer is held at a temperature within a range from 300 to 500°C. The implantation of oxygen ions during the third oxygen ion implantation step is conducted at an oxygen ion dose within a range from 1 × 10¹⁵ to 1 × 10¹⁷ atoms/cm² while the wafer is held at room temperature.

In this embodiment, oxygen ion implantation into the silicon wafer is conducted over three stages, but the oxygen ion implantation into the silicon wafer may also be conducted in a single stage, over two stages, or over 4 or more stages.

Furthermore, in this embodiment, the silicon wafer is immersed in the aqueous solution of hydrofluoric acid immediately after the first oxygen ion implantation step, but the silicon wafer may also be immersed in the aqueous solution of hydrofluoric acid immediately after the second or third oxygen ion implantation step, immediately after each of any two of the first through third oxygen ion implantation steps, or immediately after each of the three oxygen ion implantation steps.

In a SIMOX wafer manufactured in this manner, since the quantity of residual particles on the wafer surface is reduced prior to the oxygen ion implantation step, the oxygen ion implantation blocking effect caused by the particles is reduced, and as a result, the quantity of deep defects that penetrate through the SOI layer (defects that are observed after immersion of the wafer for 30 minutes at a temperature of 23°C in an aqueous solution of hydrofluoric acid 12 with a concentration of 50% by weight) can be reduced dramatically to not more than 0.05 defects/cm².

### EXAMPLES

Detailed descriptions of examples of the present invention are described below together with comparative examples.

### (Examples 1 to 3)

As shown in FIG. 2, a silicon ingot of diameter 200 mm that had been pulled up using the Czochralski method was sliced, the resulting surfaces were polished and cleaned (the first cleaning step), and oxygen ion implantation was then conducted over three steps.

As shown in FIG. 1 and FIG. 2, immediately after the first oxygen ion implantation, these wafers 11 were each subjected to an etching treatment by immersion for 60 seconds at a temperature of 23°C in an aqueous solution of hydrofluoric acid 12 that exhibited an etching rate for the SiO₂ film in the surface of the wafer 11 of 600 Å/minute (concentration of the aqueous solution of hydrofluoric acid: 10% by weight). Subsequently, the wafers 11 were immersed for 3 minutes in an overflow rinse tank 13 filled with pure water 14, and then were dried.

The wafers 11 were then cleaned using a single-wafer type spin cleaning method. Specifically, while each wafer 11 was spun individually, ozone water with a concentration of 15 ppm was sprayed onto the wafer surface for 20 seconds, and an aqueous solution of hydrofluoric acid with a concentration of 0.5% by weight was then sprayed onto the wafer surface for 10 seconds. After three repetitions of each of these cleaning processes (the second cleaning step), the wafer was dried.

The wafers 11 were then subjected to a second oxygen ion implantation step, a third cleaning step, a third oxygen ion implantation step and a fourth cleaning step, and were then subjected to a SIMOX heat treatment. These wafers are referred to as the Examples 1 to 3.

### (Examples 4 to 6)

Immediately after the first oxygen ion implantation, the wafers were each subjected to an etching treatment by immersion for 30 seconds at a temperature of 5°C in a solution prepared by adding 1 % by weight of a nonionic surfactant to an aqueous solution of hydrofluoric acid (concentration of the aqueous solution of hydrofluoric acid: 50% by weight), wherein the solution exhibited an etching rate for the SiO₂ film in the surface of the wafer of 700 Å/minute. Subsequently, the wafers were immersed for 5 minutes in the overflow rinse tank filled with pure water. With the exception of the conditions described above, three SIMOX wafers were prepared in the same manner as Examples 1 to 3. These wafers are referred to as Examples 4 to 6.

### (Examples 7 to 9)

Immediately after the first oxygen ion implantation, the wafers were each subjected to an etching treatment by immersion for 300 seconds at a temperature of 15°C in an aqueous solution of hydrofluoric acid that exhibited an etching rate for the SiO₂ film in the surface of the wafer of 400 Å/minute (concentration of the aqueous solution of hydrofluoric acid: 25% by weight). Subsequently, the wafers were immersed for one minute in the overflow rinse tank filled with pure water. With the exception of the conditions described above, three SIMOX wafers were prepared in the same manner as Examples 1 to 3. These wafers are referred to as Examples 7 to 9.

### (Examples 10 to 12)

Immediately after the first oxygen ion implantation, the wafers were each subjected to an etching treatment by immersion for 500 seconds at a temperature of 35°C in a solution prepared by adding 3% by weight of an ionic surfactant to an aqueous solution of hydrofluoric acid (concentration of the aqueous solution of hydrofluoric acid: 2% by weight), wherein the solution exhibited an etching rate for the SiO₂ film in the surface of the wafer of 350 Å/minute. Subsequently, the wafers were immersed for one minute in the overflow rinse tank filled with pure water, and then were dried. The wafers were then further cleaned by immersion in an SC-1 cleaning solution (NH₄OH : H₂O₂ : H₂O = 0.5 : 1 : 10) at 80°C for 5 minutes. With the exception of the conditions described above, three SIMOX wafers were prepared in the same manner as Examples 1 to 3. These wafers are referred to as Examples 10 to 12.

### (Comparative Examples 1 to 13)

A silicon ingot having a diameter of 200 mm that had been pulled up using the Czochralski method was sliced, the resulting surfaces were polished and cleaned (the first cleaning step), and oxygen ion implantation was then conducted over three steps.

Immediately after the first oxygen ion implantation, the wafers were cleaned by immersion in an SC-1 cleaning solution (NH₄OH : H₂O₂ : H₂O = 0.5 : 1 : 10) at 80°C for 10 minutes, and then were dried.

The wafers were then subjected to a second oxygen ion implantation step, a third cleaning step, a third oxygen ion implantation step and a fourth cleaning step, and were then subjected to a SIMOX heat treatment. These wafers are referred to as Comparative Examples 1 to 13.

### (Comparative Examples 14 to 26)

A silicon ingot having a diameter of 200 mm that had been pulled up using the Czochralski method was sliced, the resulting surfaces were polished and cleaned (the first cleaning step), and oxygen ion implantation was then conducted over three steps.

Immediately after the first oxygen ion implantation, the wafers were cleaned using a single-wafer type spin cleaning method. Specifically, while each wafer was spun individually, ozone water with a concentration of 15 ppm was sprayed onto the wafer surface for 20 seconds, and an aqueous solution of hydrofluoric acid with a concentration of 0.5% by weight was then sprayed onto the wafer surface for 10 seconds. After three repetitions of each of these cleaning processes (the second cleaning step), the wafer was dried.

The wafers were then subjected to a second oxygen ion implantation step, a third cleaning step, a third oxygen ion implantation step and a fourth cleaning step, and were then subjected to a SIMOX heat treatment. These wafers are referred to as Comparative Examples 14 to 26.

### (Comparative Examples 27 to 39)

Immediately after the first oxygen ion implantation, the wafers were each subjected to an etching treatment by immersion at a temperature of 23°C for 30 seconds in an aqueous solution of hydrofluoric acid that exhibited an etching rate for the SiO₂ film in the surface of the wafer of 30 Å/minute (concentration of the aqueous solution of hydrofluoric acid: 0.5% by weight). With the exception of these conditions, SIMOX wafers were prepared in the same manner as Example 1. These wafers are referred to as Comparative Examples 27 to 39.

### (Comparative Examples 40 to 52)

Immediately after the first oxygen ion implantation, the wafers were each subjected to an etching treatment by immersion at a temperature of 23°C for 30 seconds in an aqueous solution of hydrofluoric acid that exhibited an etching rate for the SiO₂ film in the surface of the wafer of 120 Å/minute (concentration of the aqueous solution of hydrofluoric acid: 2.0% by weight). With the exception of these conditions, SIMOX wafers were prepared in the same manner as Example 1. These wafers are referred to as Comparative Examples 40 to 52.

### (Comparative Test 1 and Evaluation)

The removal ratios for fixed point particles before and after the second cleaning step were measured for the silicon wafers of Examples 1 to 12 and Comparative Examples 1 to 52.

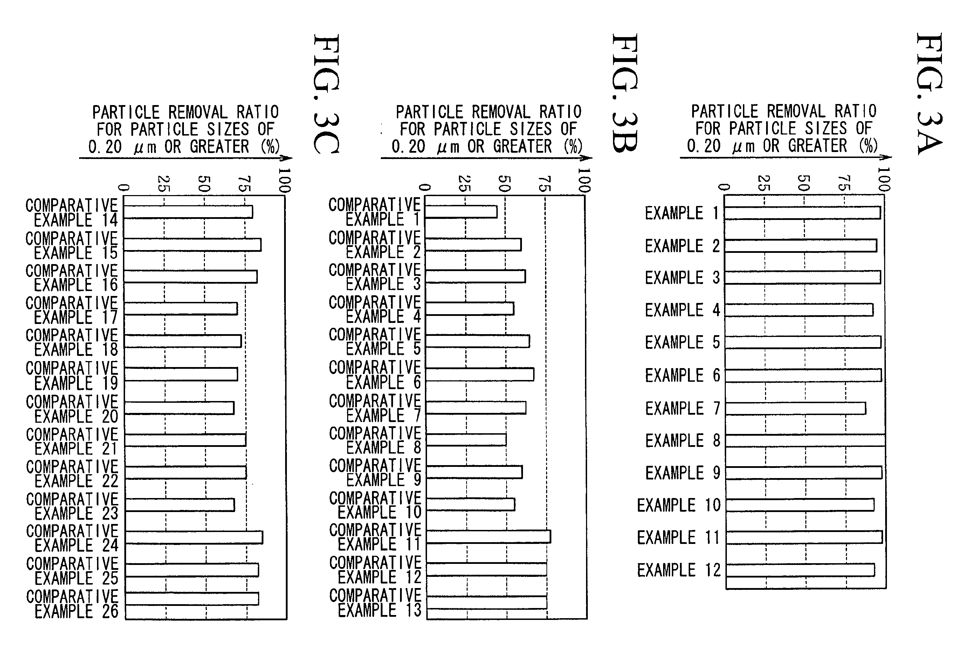

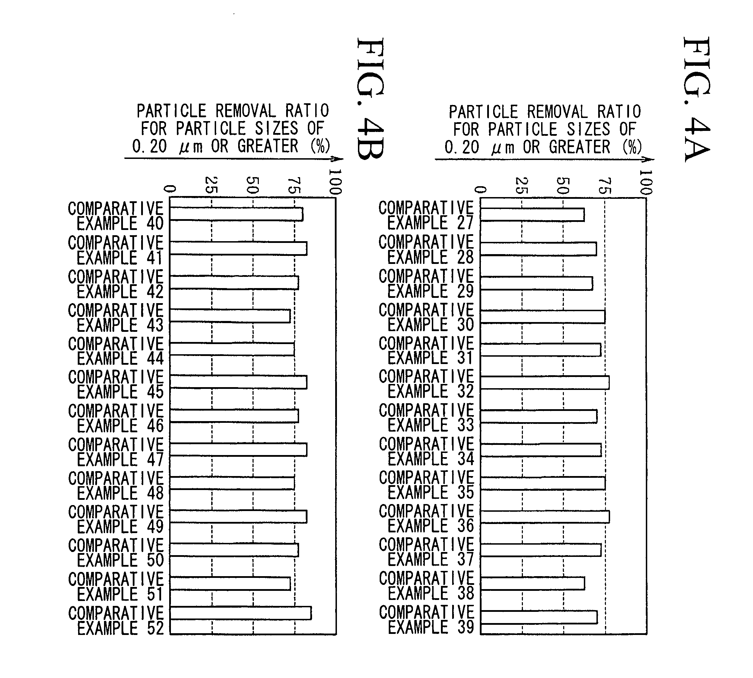

This fixed point particle removal ratio was calculated using the method described below. First, the number of particles with a particle size of 0.20 µm or greater was measured before and after the second cleaning step using a SurfScan 6420 (a surface detection apparatus, manufactured by KLA-Tencor Corporation, U.S.A.). Subsequently, the ratio obtained by dividing the number of particles with a particle size of 0.20 µm or greater after the second cleaning step by the number of particles with a particle size of 0.20 µm or greater before the second cleaning step was converted to a percentage, and this percentage was reported as the fixed point particle removal ratio. The results are shown in FIG. 3A to FIG. 3C, FIG. 4A, and FIG. 4B.

As is evident from FIG. 3A to FIG. 3C, FIG. 4A, and FIG. 4B, whereas the fixed point particle removal ratios for Comparative Examples 1 to 52 were low and fell within a range from 45 to 85%, the fixed point particle removal ratios for Examples 1 to 12 were extremely high, and were within a range from 88 to 100%. It is thought that the reason for this observation is that dividing the oxygen ion implantation into three steps, and reducing the quantity of particles immediately prior to the second oxygen ion implantation step enabled the fixed point particle removal ratio for Examples to be increased dramatically. In other words, it is thought that because the third oxygen ion implantation step is conducted at low temperature, even if some introduced particles exist, they do not become the nuclei for defects. Furthermore, because those particles that have a long residence time on the wafer relative to the ion implantation time tend to become the nuclei for defects, those particles that exist during the first and second oxygen ion implantation steps are most likely to become defect nuclei, whereas it is thought that particles that exist only during the second and third oxygen ion implantation steps are unlikely to develop into defect nuclei.

### (Comparative Test 2 and Evaluation)

The number of deep defects that penetrate through the SOI layer of the silicon wafer after the first through third oxygen ion implantation steps and the SIMOX heat treatment step was measured for the wafers of Examples 1, 4, 7 and 10, Comparative Examples 3 to 6, and Comparative Examples 16 to 19.

This number of defects was measured by immersing the wafer at 23°C for 30 minutes in an aqueous solution of hydrofluoric acid with a concentration of 50% by weight so as to expose the SOI layer defects, and then counting the number of exposed defects by inspection of the wafer under an optical microscope. The results are shown in FIG. 5.

As is evident from FIG. 5, in Comparative Examples 3 to 6 and Comparative Examples 16 to 19, the number of deep defects penetrating through the SOI layer was considerably large, and fell within a range from 17 to 26, whereas in Examples 1, 4, 7 and 10, the number of deep defects penetrating through the SOI layer was within a range from 0 to 5, meaning that the number of defects within a SIMOX wafer having a diameter of 200 mm was not more than 0.016 defects/cm², which represents an extremely low value.

### INDUSTRIAL APPLICABILITY

According to the method for manufacturing a SIMOX wafer of the present invention, because strong particle bonds containing large quantities of silicon and oxygen bonds can also be broken, particles can be almost completely removed from the surface of the silicon wafer. As a result, a SIMOX wafer with extremely few defects can be manufactured.

## Claims

1. A method for manufacturing a SIMOX wafer, the method comprising:
implanting oxygen ions in a silicon wafer;
cleaning said silicon wafer into which said oxygen ions are implanted; and
forming a buried oxide film within an interior of said silicon wafer by subjecting said cleaned silicon wafer to a heat treatment,
wherein said method further comprises immersing said silicon wafer in an aqueous solution of hydrofluoric acid and etching a SiO₂ film formed on a surface of said silicon wafer, which is conducted after said implanting of oxygen ions in said silicon wafer, but prior to said cleaning of said silicon wafer, and
an etching rate for said SiO₂ film by said aqueous solution of hydrofluoric acid during said etching treatment is within a range from 150 to 3,000 (Å/minute).

2. A method for manufacturing a SIMOX wafer according to claim 1, wherein oxygen ion implantation into said silicon wafer is conducted over a plurality of steps, and said silicon wafer is immersed in said aqueous solution of hydrofluoric acid either immediately after any one of said plurality of implantation steps, or immediately after each of two or more of said implantation steps.

3. A method for manufacturing a SIMOX wafer according to claim 1 or 2, wherein a temperature of said aqueous solution of hydrofluoric acid exceeds a freezing point of said aqueous solution of hydrofluoric acid, and is not greater than 40°C, and
an immersion time for said silicon wafer within said aqueous solution of hydrofluoric acid is within a range from 10 to 600 seconds.

4. A method for manufacturing a SIMOX wafer according to claim 1 or 2, wherein if an etching rate for said SiO₂ film by said aqueous solution of hydrofluoric acid is termed R (Å/minute), and an immersion time of said silicon wafer within said aqueous solution of hydrofluoric acid is termed H (seconds), said immersion time is set so that H ≥ (1500/R) (seconds).

5. A method for manufacturing a SIMOX wafer according to claim 1, wherein a surfactant is added to said aqueous solution of hydrofluoric acid.

6. A SIMOX wafer, which is manufactured using a method for manufacturing a SIMOX wafer according to claim 1, and has a quantity of deep defects that penetrate through a SOI layer, which are defects that are observed after immersion of said wafer for 30 minutes at a temperature of 23°C in an aqueous solution of hydrofluoric acid with a concentration of 50% by weight, of not more than 0.05 defects/cm².
